Europäisches Patentamt

European Patent Office

Office européen des brevets

(19)

(11) Numéro de publication: **0 007 276**
**B1**

(12) **FASCICULE DE BREVET EUROPEEN**

(45) Date de publication du fascicule du brevet: **15.09.82**

(51) Int. Cl.³: **H 04 L 27/14, H 03 H 9/64**

(21) Numéro de dépôt: **79400481.2**

(22) Date de dépôt: **10.07.79**

(54) Dispositif de démodulation de signaux modulés par déplacement de fréquence.

(30) Priorité: **12.07.78 FR 7820809**

(43) Date de publication de la demande:
**23.01.80 Bulletin 80/2**

(45) Mention de la délivrance du brevet:
**15.09.82 Bulletin 82/37**

(84) Etats contractants désignés:
**BE CH DE GB IT NL SE**

(56) Documents cités:
**US - A - 3 691 464**

**WAVE ELECTRONICS, vol. 1, no. 5—6, juin 1976 Amsterdam, NL. J. H. COLLINS et al. "Application of surface acoustic wave devices to spread spectrum communications" pages 311— 342.**
**PROCEEDINGS OF THE IEEE, vol. 64, no. 5, mai 1976 New York USA D. P. MORGAN et al. "Spread-spectrum synchronizer using a SAW convolver and recirculation loop", pages 751— 753.**

(73) Titulaire: **THOMSON-CSF**
**173, Boulevard Haussmann**
**F-75360 Paris Cedex 08 (FR)**

(72) Inventeur: **Laurent, Pierre**
**"THOMSON-CSF" - SCPI 173, bld Hausmann**
**F-75360 Paris Cedex 08 (FR)**

(74) Mandataire: **Courtellemont, Alain et al,**
**THOMSON-CSF SCPI 173, Bld Haussmann**
**F-75360 Paris Cedex 08 (FR)**

(56) Documents cités:
**ALTA FREQUENZA, vol. 43, no. 10, octobre 1974, Milan, IT. C. ATZENI et al. "Design of surface acoustic wave filters", pages 601E— 865 à 611E—875.**

Courier Press, Leamington Spa, England.

Dispositif de démodulation de signaux modulés par déplacement de fréquence

La présente invention concerne les dispositifs permettant de démoduler des signaux modulés par déplacement de fréquence et composés de séquences se déduisant les unes des autres par permutations circulaires, et en particulier des signaux modulés par déplacement de fréquence à spectre minimal.

Une modulation par déplacement de fréquence à spectre minimal (MFSK dans la littérature anglo-saxonne) est une modulation bifréquence codée, caractérisée par un signal modulé ayant une amplitude constante, une variation de phase continue, et un encombrement spectral minimal. D'après certaines publications (IEEE Transactions on Communications, April 1977 page 433) cette modulation est considérée, pendant la durée de chaque séquence, soit comme une modulation par déplacement de fréquence d'un signal de fréquence $F_c$ (modulation F.S.K ou Frequency Shift Keying dans la littérature anglo-saxonne), le signal modulé résultant présentant deux fréquences

$$F_1 = F_c - \frac{F_b}{4} \text{ et } F_2 = F_c + \frac{F_b}{4}$$

($F_b$ étant la fréquence des bits transmis), soit comme un cas particulier de modulation à déplacement de phase quaternaire (modulation QPSK ou Quaternary Phase Shift Keying dans la littérature anglo-saxonne).

Un signal modulé par "déplacement de fréquence à spectre minimal" peut être obtenu par sommation de deux porteuses en quadrature de phase modulées indépendamment l'une de l'autre par deux signaux modulants définis de la façon suivante:

— l'intervalle entre deux annulations de l'amplitude de chacun des deux signaux modulants est égal à

$$\frac{2}{F_b} = 2\tau;$$

entre ces annulations les signaux modulants sont constitués de demi-cycles de sinusoïde dont le signe +1 ou −1 de l'amplitude est déterminé par un code

— les annulations de chacun des signaux modulants sont respectivement décalées de $\tau$.

Pour réaliser ces modulations, les deux porteuses sont respectivement multipliées analogiquement par les deux signaux modulants; il est à noter que cette modulation entraîne, pour chaque porteuse modulée, une modulation de phase o ou $\pi$ à chaque annulation de l'amplitude du signal modulant.

Pour réaliser un dispositif de démodulation de signaux ainsi modulés, il est connu d'utiliser des démodulateurs à asservissement de phase (tels que décrits dans IEEE Transactions on Communications, October 1973 page 1529) assurant une démodulation cohérente sur deux voies en quadrature. Ces démodulateurs sont adaptés à une démodulation d'un signal modulé de façon continue mais non à la démodulation d'un signal modulé par séquences.

La présente invention a pour objet de remédier aux inconvénients de ces démodulateurs.

Selon l'invention, un dispositif de démodulation de signaux modulés par déplacement de fréquence à spectre minimal, ces signaux étant constitués de séquences de n trains d'oscillations (n entier supérieur à 1), chaque train ayant l'une ou l'autre de deux fréquences $F_1$ et $F_2$ et une durée $\tau$ et les séquences de n trains possibles étant déduites, par permutations circulaires, d'une séquence de base et représentatives d'un code binaire à permutation circulaire à n codes, est caractérisé en ce que l'entrée de ce dispositif est couplée aux voies d'entrée de deux voies de filtrage adaptées à une séquence d'accord qui est l'une des séquences du code, ces deux voies de filtrage ayant des voies d'entrée décalées de la durée $n\tau$ d'une séquence et une voie de sortie commune, cette voie de sortie étant couplée à un dispositif de détection ($I_i$, 7, 8) qui détecte dans le signal reçu par la voie sortie, l'instant où ce signal correspond à la réponse attendue pour la séquence d'accord, la position de cet instant dans un intervalle $n\tau$ donnant le nombre de permutations circulaires de la séquence d'accord à la séquence reçue et donc la séquence codée reçue.

L'invention sera mieux comprise et d'autres caractéristiques apparaîtront à l'aide de la description et des dessins s'y rapportant sur lesquels:

— la figure 1, représente des chronogrammes de signaux permettant d'expliquer la modulation par déplacement de fréquence à spectre minimal;
— la figure 2 est un schéma de principe d'un filtre adapté à une séquence de signaux modulés par déplacement de fréquence à spectre minimal;
— la figure 3 est un schéma d'un premier mode de réalisation préféré du dispositif selon l'invention;
— la figure 4 est un schéma d'un second mode de réalisation préféré du dispositif selon l'invention;
— la figure 5 est un schéma détaillé d'un élément commun aux figures 3 et 4.

Les éléments qui se correspondent identiquement d'une figure à l'autre sont désignés par le même repère.

On considère un signal *a* résultant du produit analogique d'un signal porteur, ayant une fréquence $F_c$, et d'un signal modulant constitué de demi-cycles de sinusoïde de durée $2\tau$,

$$f=\frac{1}{4\tau},$$

f étant la "pseudo-fréquence" du signal modulant. L'équation d'un tel signal est la suivante:

$$\varepsilon_1 \cos 2\pi F_c t . \sin\frac{\pi}{2\tau}t$$

($\varepsilon_1$ étant égal à $\pm 1$ et ne pouvant changer de valeur qu'aux instants d'annulation de l'amplitude du signal modulant).

$$\varepsilon_2 \sin 2\pi(F_c + \frac{\varepsilon_1}{\varepsilon_2} . \frac{1}{4\tau})t \text{ avec} \begin{cases} F_c + \dfrac{1}{4\tau}=F_2 \text{ si} \dfrac{\varepsilon_1}{\varepsilon_2}=+1 \\ \\ F_c - \dfrac{1}{4\tau}=F_1 \text{ si} \dfrac{\varepsilon_1}{\varepsilon_2}=-1 \end{cases}$$

Ce signal somme *c* est un signal modulé "par déplacement de fréquence à spectre minimal" ayant une variation de phase continue et une amplitude constante. L'expérience montre et le calcul confirme que ces caractéristiques ne sont obtenues qu'à la condition suivante:

$$\omega_c . \tau=\frac{\pi}{2}+k\pi \text{ avec k entier positif}$$

cette relation entraîne, entre la fréquence $F_c$ et la pseudo-fréquence f, la relation suivante $F_c=(2k+1)f$.

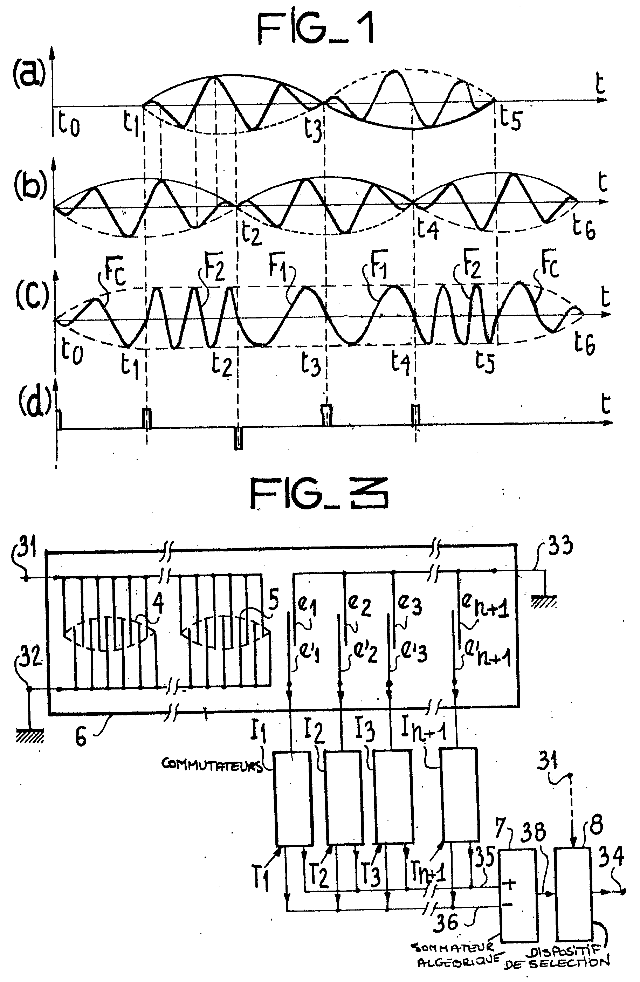

Sur la figure 1 est représenté un signal *a* supposé n'exister qu'entre les instants $t_1$ et $t_5$, avec $\varepsilon_1=1$ entre les instants $t_1$ et $t_3$ et $\varepsilon_1=+1$ entre les instants $t_3$ et $t_5$ (signal modulant en trait plein dont l'amplitude ne change pas de signe lors de l'annulation); en outre il est à noter que $t_5-t_3=t_3-t_1=2\tau$. Un tel signal *b* supposé n'exister qu'entre les instants $t_0$ et $t_6$ est représenté sur la figure 1 avec:

$\varepsilon_2=1$ entre les instants $t_0$ et $t_2$;
$\varepsilon_2=-1$ entre les instants $t_2$ et $t_4$;
$\varepsilon_2=1$ entre les instants $t_4$ et $t_6$ (signal modulant en trait plein avec changement de signe de l'amplitude à chaque annulation)

$$\text{et}\frac{t_6-t_4}{2} = \frac{t_4-t_2}{2} = \frac{t_2-t_0}{2}=t_1-t_0=\tau$$

La somme de ces signaux *a* et *b* est représentée par le signal *c* de la figure 1. La frétude du signal modulant). On considère de même un second signal *b* résultant du produit analogique d'un signal porteur de fréquence $F_c$, en quadrature de phase par rapport au précédent, et d'un signal modulant de même type que le précédent mais dont l'amplitude s'annule à des instants décalés de $\tau$ par rapport aux instants d'annulation de l'amplitude du signal modulant précédent. L'équation d'un tel signal est la suivante:

$$\varepsilon_2 \sin 2\pi F_c t . \cos\frac{\pi}{2\tau}t$$

($\varepsilon_2$ étant égal à $\pm 1$ et ne pouvant changer de valeur qu'aux instants d'annulation de l'amplitude du signal modulant).

La somme des deux signaux *a* et *b* est un signal *c* dont l'équation est donnée par la relation suivante:

quence de ce signal *c* varie de la façon suivante d'une durée $\tau$ à l'autre:

— entre les instants $t_0$ et $t_1$: fréquence $F_c$ (partie non significative du message)
— entre les instants $t_1$ et $t_2$:

$$\text{fréquence } F_2 \text{ car}\frac{\varepsilon_1}{\varepsilon_2}=1$$

— entre les instants $t_2$ et $t_3$:

$$\text{fréquence } F_1 \text{ car}\frac{\varepsilon_1}{\varepsilon_2}=-1$$

— entre les instants $t_3$ et $t_4$:

$$\text{fréquence } F_1 \text{ car}\frac{\varepsilon_1}{\varepsilon_2}=-1$$

— entre les instants $t_4$ et $t_5$:

$$\text{fréquence } F_2 \text{ car}\frac{\varepsilon_1}{\varepsilon_2}=+1$$

— entre les instants $t_5$ et $t_6$: fréquence $F_c$ (partie non significative du message)

En outre dans les équations des signaux *a* et *b* susmentionnés, le déphasage à l'origine entre

le signal porteur et le signal modulant est de $\pi/4$ (cas particulier de la figure 1), mais il est à noter que ce déphasage peut prendre n'importe quelle valeur.

La synthèse d'un signal tel que $c$ peut également être réalisée avec un filtre ayant pour réponse impulsionnelle le train d'oscillations de fréquence $F_c$ du signal $a$ pris entre les instants $t_1$ et $t_3$, et recevant sur son entrée le signal $d$, de la figure 1, constitué d'une suite de n+1 impulsions brèves de période $\tau$.

Les conditions nécessaires à l'obtention des fréquences $F_1$ et $F_2$ sont alors les suivantes:

— fréquence $F_2$ si les deux dernières impulsions consécutives sont de même signe
— fréquence $F_1$ si les deux dernières impulsions consécutives sont de signe contraire.

En fait, entre les instants $t_1$ et $t_5$, le signal $c$ représente un signal modulé bifréquence dont les deux valeurs de fréquences $F_1$ et $F_2$ peuvent être utilisées pour traduire un code binaire à permutations circulaires.

Le codage binaire à permutations circulaires d'une première information se traduit généralement par une première séquence de n bits dans laquelle les bits sont ordonnés d'une façon prédéterminée, cette séquence, appelée "séquence de base" dans ce qui suit, étant séparée de la suivante par une absence de signal d'une durée donnée (soit 0011 un exemple de séquence de base).

Les autres séquences comportant les informations suivantes, séparées entre elles par une absence de signal, sont obtenues par permutations circulaires de la séquence initiale (soient 1001, 1100 et 0110 en reprenant l'exemple ci-dessus). Cette modulation par séquences est un cas particulier de la "modulation n-aire", n étant le nombre de permutations circulaires utilisées.

Chaque séquence de n bits (4 dans l'exemple ci-dessus) correspond à une information élémentaire à transmettre (par exemple une lettre de l'alphabet); donc avec une "séquence de base" telle que les n séquences, déduites l'une de l'autre par permutation circulaire, ne soient pas identiques (une séquence de base de 4 bits 0101 ne conviendrait pas car elle redonne deux fois les mêmes codes lors des permutations circulaires) il est possible de transmettre n informations élémentaires différentes.

On suppose, dans ce qui suit, que les signaux à démoduler ont été obtenus suivant le procédé indiqué plus haut à l'aide d'un filtre ayant pour réponse impulsionnelle le train d'oscillations du signal $a$, pris entre les instants $t_1$ et $t_3$. Ce filtre étant appelé ci-après "filtre d'émission", les symboles 0 et 1 étant codés par des trains d'oscillations de fréquences respectives $F_1$ et $F_2$.

Par exemple, le signal (c) de la figure 1 correspond à une séquence de code 1001, déduite de la séquence de base 0011; et peut être généré avec un suite d'impulsions de période $\tau$ successivement positive, positive, négative, positive et positive (signal (d) de la figure 1).

La démodulation de tels signaux codés par permutations d'une séquence de base modulée par déplacement de fréquence a pour but de restituer une impulsion dont la position dans le temps à l'intérieur d'un intervalle de durée n. $\tau$ est fonction de l'information reçue.

Pour identifier une séquence de code connu, l'expérience montre et le calcul confirme qu'il suffit d'utiliser comme démodulateur, un filtre adapté à cette séquence; on entend ici et dans les revendications par filtre adapté à un train d'oscillations de fréquence $F_c$ ou à une séquence telle que définie, un filtre dont la réponse impulsionnelle est l'inverse dans le temps du train ou de la séquence compte non tenu de la phase à l'origine de la fréquence porteuse. Un filtre adapté à un signal de durée finie est celui dont la réponse impulsionnelle est ce même signal inverse dans le temps.

Le principe d'un tel filtre adapté décrit dans un article de COLLINS et al publié dans Wave Electronics vol. 1, n° 5—6, pages 311—342 de juin 1976, sera exposé à l'aide de la figure suivante.

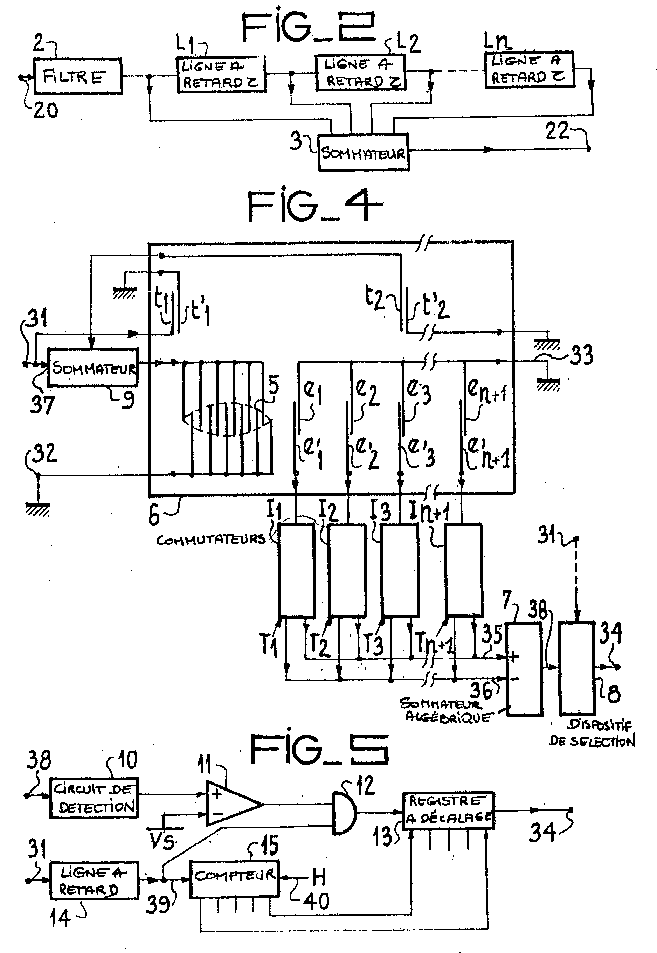

Sur la figure 2, un filtre 2, recevant la séquence de code connu de n bits sur son entrée 20, alimente par sa sortie 21, n lignes à retard $L_1$ à $L_n$ disposées en série et imposant chacune un retard égal à $\tau$. La sortie 21 du filtre 2 ainsi que la sortie de chaque ligne à retard $L_1$ à $L_n$ sont respectivement reliées aux n+1 entrées d'un dispositif de sommation 3 dont la sortie 22 constitue la sortie du filtre adapté. Il est à noter que chaque entrée du dispositif de sommation 3 inverse ou non le signal qui lui est appliqué pour permettre de réaliser le filtre adapté à la séquence de code connu.

Le fonctionnement de ce dispositif est le suivant.

Le filtre 2 présente une réponse impulsionnelle ayant la forme d'un train d'oscillations de fréquence $F_c$, appelé "signal de base" dans ce qui suit semblable au signal $a$ de la figure 1 pris entre les instants $t_1$ et $t_3$. D'après ce qui a été dit plus haut l'enveloppe de la modulation d'amplitude du signal de base étant symétrique dans le temps, le filtre 2 est un filtre adapté à ce signal de base. Il est à noter que le filtre 2 du démodulateur et le filtre d'émission doivent avoir des caractéristiques aussi proches que possible et, par exemple lorsque ces filtres sont à ondes acoustiques de surface, être réalisés simultanément par les mêmes masques (en intégration monolithique), afin qu'une dissymétrie accidentelle du filtre d'émission soit reproduite sur la filtre 2. Le filtre 2, recevant la séquence à identifier, fournit un signal qui est reproduit à la sortie de chaque ligne à retard $L_1$ à $L_n$ avec des retards respectifs de valeur $\tau$ à n$\tau$. Les signaux de sortie du filtre et des lignes à retard sont sommés algébriquement par le dispositif de sommation 3. Cette sommation algébrique est réalisée suivant un code inversé dans le temps par rapport aux impulsions ayant donné lieu, à la génération de la séquence (par exemple un code inverse dans le temps de celui du signal *d* de la figure 1 si la séquence reçue est le signal (C). Ce démodulateur constitue donc un filtre adapté à cette séquence à identifier.

L'expérience montre et le calcul confirme que le signal de sortie d'un filtre adapté à une séquence donnée présente pour cette séquence d'accord un maximum d'amplitude supérieur aux maxima d'amplitude qu'il peut présenter pour les autres séquences du même code.

Le principe du démodulateur suivant l'invention consiste à adjoindre, à un filtre adapté à une séquence dite "d'accord", normalement la "séquence de base", un dispositif de répétition de la séquence reçue en un point ou un autre de ce filtre permettant d'obtenir du démodulateur, pour une séquence reçue, la même réponse que s'il l'avait reçue deux fois de suite.

Dans la séquence constituée de deux fois la séquence reçue et du fait que le codage est à permutation circulaire, il est possible de détecter une réponse correspondant à la séquence d'accord, le filtre étant adapté à cette séquence; l'instant d'apparition du maximum correspondant est fonction de la séquence reçue.

Ainsi si la séquence reçue est 1001 et que la séquence d'accord est la séquence de base 0011, la répétition de la séquence reçue fait apparaître dans la réponse un maximum pour la séquence d'accord à laquelle le filtre est adapté à un instant donné: 10<u>0011</u>001, cet instant étant directement lié à la séquence reçue.

Dans le premier mode de réalisation illustré par la figure 3 on utilise un filtre à ondes acoustiques de surface comportant deux transducteurs d'entrée couplés à un même transducteur de sortie, et dont chacun forme avec le transducteur de sortie un filtre tel que le filtre 2 de la figure 2.

Sur la figure 3, un substrat piézoélectrique de quartz 6 comporte un premier jeu d'électrodes métalliques parallèles, de différentes longueurs et alimentées en parallèle par le signal reçu sur l'entrée 31. Ce substrat 6 comporte également un deuxième jeu d'électrodes métalliques, parallèles entre elles et parallèles aux électrodes du premier jeu, présentant différentes longueurs, et ayant une extrémité reliée à l'entrée 32 par une connexion commune, l'entrée 32 étant elle-même reliée à la masse. Ces deux jeux d'électrodes sont entrelacés et leur zone d'interpénétration est symbolisée par le pourtour 4 en pointillé (correspondant à la forme de la réponse impulsionnelle du filtre). Le substrat 6 comporte également un troisième et un quatrième jeux d'électrodes identiques et parallèles aux précédents, également reliés aux entrées 31 et 32 (ayant un pourtour d'interpénétration 5), et décalés des précédents d'une distance donnée correspondant au temps de propagation $T = n\tau$, de l'onde acoustique de surface, dans le substrat 6.

Le substrat 6 comporte un cinquième jeu d'électrodes métalliques $e_1$ à $e_{n+1}$, parallèles entre elles et parallèles aux électrodes du deuxième jeu, présentant des longueurs égales ayant une extrémité reliée à la sortie 33 par une connexion commune, la sortie 33 étant elle-même reliée à la masse. Ce substrat comporte également un sixième jeu d'électrodes métalliques $e'_1$ à $e'_{n+1}$, toutes de même longueur, parallèles entre elles et parallèles aux électrodes du cinquième jeu. Ces cinquième et sixième jeux d'électrodes sont entrelacés, et ont leurs électrodes $e'_1$ à $e'_{n+1}$ respectivement très proches des électrodes $e_1$ à $e_{n+1}$ mais espacées entre elles d'une distance donnée $l_1$ telle quel $l_1 = e'_{n+1} - e'_n = e_{n+1} - e_n = \cdots$

$$= e_3 - e_2 = e_2 - e_1 = e'_2 - e'_1.$$

La notation $e_{j+1} - e_j$ ou $e'_{j+1} - e'_j$ signifie que l'on considère la distance entre ces électrodes. Cette distance donnée correspond à un temps de propagation égal à $\tau$ ($\tau$ étant le retard susmentionné lors de la description de la figure 2), d'une onde acoustique de surface de fréquence $F_c$ se propageant d'une paire d'électrodes $e_j$, $e'_j$ à la paire d'électrodes suivante $e_{j+1}$, $e'_{j+1}$. Les extrémités des électrodes $e'_1$ à $e'_{n+1}$, non en regard des électrodes $e_1$ à $e_n$, sont respectivement reliées à l'entrée de commutateurs $I_1$ à $I_{n+1}$ respectivement commandés par des états de signaux logiques $T_1$ à $T_{n+1}$. Une première sortie de ces commutateurs est reliée à une entrée (+) 35 d'un sommateur algébrique 7, et une seconde sortie l'est à une entrée (−) 36 de ce sommateur 7 ayant une borne de sortie 38 reliée à la sortie 34 du dispositif, à travers un dispositif de sélection 8 commandé par le signal reçu sur l'entrée 31.

Les signaux logiques $T_1$ à $T_{n+1}$ permettent de commander les commutateurs $I_1$ à $I_{n+1}$ pour relier respectivement les électrodes $e'_1$ à $e'_{n+1}$ à l'entrée 35 si leur état logique est à l'état "1" et à l'entrée 36 si leur etat logique est à l'état "0".

Ce dispositif de démodulation a été réalisé pour une fréquence $F_c$ de 68,75 MHz, une valeur de $\tau$ de 200 ns et pour n=32.

Le fonctionnement de ce dispositif est le suivant.

L'ensemble des premier et deuxième jeux d'électrodes constitue un transducteur d'entrée qui, par effet piézoélectrique, convertit les signaux électriques reçus sur l'entrée 31 en une onde acoustique de surface de forme identique à la réponse électrique de ce transducteur. L'ensemble des troisième et quatrième jeux d'électrodes constitue un transducteur de sortie qui reçoit cette onde et la transforme, par effet piézoélectrique inverse, en un signal électrique (Proceeding of the IEEE, May 1976, Vol. 64, n° 5, pages 581 à 595) de forme identique à celle de l'onde acoustique de surface.

En outre l'ensemble des premier et deuxième jeux d'électrodes ainsi que les troisième et quatrième jeux d'électrodes constituent chacun un filtre ayant pour réponse impulsionnelle un train d'oscillations de fréquence $F_c$ dont l'enveloppe est donnée par le pourtour 4 de la figure 3 (Proceeding of the IEEE, May 1976, vol. 64, n° 5, pages 639 à 651). Ces ensembles constituent donc respectivement deux filtres tels que le filtre 2 de la figure 2, et la distance entre les entrées permet de répéter la séquence reçue.

De même l'ensemble des troisième et quatrième jeux d'électrodes est identique à une ligne à retard comportant n retards élémentaires de valeur $\tau$. Cette ligne à retard est donc identique aux n lignes à retard de la figure 2.

Les commutateurs $I_1$ à $I_{n+1}$ permettent de réaliser le codage de cette partie du démodulateur, suivant l'inverse dans le temps du code d'impulsions générant la "séquence d'accord", qui sera appelé "code d'accord" dans ce qui suit (ce codage était réalisé par les entrées du dispositif de sommation 3 de la figure 2 pour un code fixe et connu). Pour la séquence d'accord 0011 qui est générée par une suite de cinq impulsions successivement positive, négative et positive 3 fois, le code d'accord sera tel que les commutateurs $I_1$ à $I_5$ seront reliés à l'entrée+du sommateur sauf $I_2$ qui sera relié à l'entrée—.

Le fonctionnement de ce dispositif est le suivant.

Le codage du démodulateur (en "code d'accord") est réalisé par l'état logique des signaux $T_1$ à $T_{n+1}$.

Lorsque l'entrée 31 reçoit, à un instant t', une séquence déduite de la séquence de base par permutations circulaires et correspondant à une information donnée, cette séquence est transférée du transducteur d'entrée ayant le pourtour d'interpénétration 5 sur les n+1 dernières paires d'électrodes $e_1$, $e'_1$ à $e_{n+1}$, $e'_{n+1}$ du transducteur de sortie, avec un retard $\theta$ ($\theta$ étant le temps de propagation, dans le substrat 6, entre les transducteurs d'entrée et de sortie). En général l'amplitude maximale ne sera pas encore obtenue du fait de la non coïncidence de la séquence reçue avec la séquence d'accord (filtre non adapté à la séquence reçue). La séquence reçue par le transducteur d'entrée ayant le pourtour d'interpénétration 4 sera fournie aux électrodes du transducteur de sortie au fur et à mesure que la séquence fournie par le précédent transducteur d'entrée (ayant le pourtour d'interpénétration 5) quitte les électrodes du transducteur de sortie, du fait que la distance séparant les deux transducteurs d'entrée correspond à un retard $T=n\tau$. A un instant donné la séquence présente sur les électrodes du transducteur de sortie, et due à la somme des informations partielles provenant des deux transducteurs d'entrée, coïncidera avec la réponse pour la séquence d'accord; à cet instant apparaîtra à la sortie du sommateur algébrique l'amplitude maximale susmentionnée. Ensuite les informations continuent à se propager d'une paire d'électrodes à la suivante. Il est à noter que la durée de propagation des informations sur ces paires d'électrodes, pendant laquelle la sortie du sommateur algébrique 7 est susceptible de délivrer un signal, est de $3n\tau$.

Il est en outre à noter que cette amplitude maximale sera en général accompagnée de deux maxima d'amplitude inférieure ou égale, ces maxima étant dus au fait que l'information contenue sur les électrodes du transducteur de sortie coïncide partiellement avec la réponse pour la "séquence d'accord". Ces deux maxima seront situés, temporellement, de part et d'autre de l'amplitude maximale. D'ou la nécessité d'un dispositif permettant de sélectionner l'amplitude maximale dont la position temporelle traduit l'information utile contenue dans la séquence reçue. Cette amplitude maximale ne peut être obtenue qu'entre les instants $t'+n\tau+\theta$ et $t'+2n\tau+\theta$ si t' est l'instant de début de réception (correspondant à l'instant $t_1$ du signal c de la figure 1) de la séquence; on a supposé dans ce qui précède que lors de l'émission on ait supprimé (à l'aide d'un interrupteur commandé et disposé en série sur la ligne de signal) les parties du signal correspondant à celles du signal c de la figure 1 comprises entre les instants $t_0$ et $t_1$ d'une part et $t_5$ et $t_6$ d'autre part.

Le dispositif permettant de sélectionner et d'exploiter l'amplitude maximale est le dispositif de sélection 8 de la figure 3 qui est représenté en détail sur la figure 5.

Il est à noter que la séquence d'accord n'est pas nécessairement la "séquence de base", et que si on ne désire pas avoir la possibilité de modifier la "séquence d'accord" les commutateurs $I_1$ à $I_{n+1}$ peuvent être supprimés et le sommateur algébrique 7 remplacé par un simple additionneur. Dans ce cas le codage du démodulateur est réalisé au niveau du transducteur de sortie en plaçant les électrodes $e_i$ ($1 \leqslant i \leqslant n+1$) en amont ou en aval des électrodes correspondantes $e'_i$ (par rapport à la direction de propagation de l'onde acoustique de surface) suivant que l'on désire une pondération par +1 ou par —1.

Dans un second mode de réalisation, illustré par la figure 4, le dispositif de répétition est disposé en amont d'un filtre tel que le filtre 2 de la figure 2.

Sur la figure 4, une première entrée 37 d'un sommateur 9 est reliée à une électrode $t_1$ et à l'entrée 31 du dispositif de démodulation. Une seconde entrée de ce sommateur 9 est reliée à une électrode $t_2$ et sa sortie est reliée à un transducteur d'entrée identique à celui de la figure 3 (pourtour d'interpénétration 5). Une paire d'électrodes $t_1$, $t'_1$ ($t'_1$ étant très proche de l'électrode $t_1$ et étant reliée à la masse) est associée à une paire d'électrodes $t_2$, $t'_2$ ($t'_2$ étant très proche de l'électrode $t_2$ et étant reliée à la masse). La distance entre ces paires d'électrodes constitue une ligne à retard imposant au signal reçu sur l'entrée 31 un retard égal à $T=n\tau$ (même retard que celui de la figure 3). Les élec-

trodes $e_1$ à $e_{n+1}$ et $e'_1$ à $e'_{n+1}$, les commutateurs $I_1$ à $I_{n+1}$, le sommateur algébrique 7, le dispositif de sélection 8 ainsi que le substrat 6 sont identiques à ceux de la figure 3 et connectés entre eux de la même façon.

Le fonctionnement de ce dispositif se déduit du fonctionnement du dispositif de la figure 3.

En effet lorsque l'entrée 31 reçoit, à un instant $t'$, une séquence, cette séquence est transférée à la première paire d'électrodes du transducteur de sortie avec un retard $\theta$ ($\theta$ étant le temps de propagation dans le substrat 6 entre les transducteurs d'entrée et de sortie). Une seconde séquence identique à la précédente mais décalée d'un retard $T=n\tau$ sera progressivement appliquée sur les électrodes du transducteur de sortie comme pour le dispositif de la figure 3 (du fait de la ligne à retard constituée des paires d'électrodes $t_1$, $t'_1$ et $t_2$, $t'_2$ et du sommateur 9).

Le schéma détaillé du dispositif de sélection 8 des figures 3 et 4 est donné par la figure suivante.

Sur la figure 5 l'entrée (+) d'un comparateur analogique 11 est reliée à la borne 38, à travers un circuit de détection 10, l'entrée (−) de ce comparateur 11 est reliée à une tension de seuil $V_s$, et la sortie du comparateur 11 est reliée à une première entrée d'une porte ET, 12, ayant une seconde entrée reliée à la sortie d'une ligne à retard 14. La sortie de la porte ET, 12, est reliée à une entrée "horloge" d'un registre à décalage 13 ayant m étages, m tel que $2^{m-1}<n\leqslant2^m$ et ayant une sortie 34 constituant la sortie du dispositif. Un compteur binaire 15, ayant m étages, reçoit sur une entrée 40 un signal d'horloge H de période $\tau$, et comporte une entrée 39 qui est reliée à l'entrée 31 recevant le signal à démoduler, à travers la ligne à retard 14 imposant à ce signal un retard $T=n\tau+\theta$. Les sorties des m étages du compteur 15 sont respectivement reliées aux m entrées respectives des m étages du registre à décalage 13.

Le fonctionnement de ce dispositif est le suivant.

Le signal reçu par le circuit de détection 10 est le signal de sortie du sommateur algébrique 7 (figures 3 et 4). Ce signal, décrit précédemment lors de l'étude de la figure 3, a une durée de $3n\tau$ (car le début et la fin de la séquence reçue ne comporte pas de signal à la fréquence $F_c$) et comporte l'impulsion maximale utile entre les instants $t'+n\tau+\theta$ et $t'+2n\tau+\theta$ si $t'$ est le début de réception de la séquence. Le circuit de détection 10 et son filtre passe bas associé (non représenté) permet de fournir à l'entrée (+) du comparateur 11 la courbe enveloppe positive du signal reçu sur la borne 38.

Le comparateur 11 fournit sur sa sortie un état "1" logique lorsque l'amplitude du signal reçu sur son entrée (+) est supérieure à la tension de seuil $V_s$ et un état "0" logique dans le cas contraire. Le signal de sortie de ce comparateur 11 peut donc être à l'état "1" pour l'amplitude maximale utile, mais également pour les deux maxima d'amplitude situés dans le premier et le dernier tiers de la durée $3n\tau$ du signal reçu sur la borne 38. La ligne à retard 14 et le compteur 15 associés à la porte ET, 12, permettent de sélectionner l'amplitude maximale utile.

Le signal de sortie de la ligne à retard (donc sur la deuxième entrée de la porte ET, 12, et sur l'entrée 39 du compteur 15) est à l'état "1" logique à l'instant $t'+n\tau+\theta$. Cet état "1" logique débloque le compteur 15 qui compte de 0 à $n-1$ pendant une durée $n\tau$ (durée de la séquence reçue) au rythme de son horloge de période $\tau$, et permet d'ouvrir la porte ET, 12 et ainsi de sélectionner l'amplitude maximale utile. Le signal de sortie de la porte ET, 12, est donc à l'état "1" logique pendant la période $\tau$ de comptage correspondant à la position dans le temps de l'amplitude maximale utile. Cet état "1" logique permet alors au registre à décalage 13 d'enregistrer l'état du compteur. Le contenu de ce registre est ensuite lu sous forme série sur sa sortie 34.

L'invention n'est pas limitée aux modes de réalisation décrits et représentés, en particulier les dispositifs de démodulation selon l'invention peuvent être réalisés selon les variantes suivantes.

Les pourtours 4 et 5 des zones d'interpénétration des premier et deuxième jeux d'électrodes sont identiques au signal, $a$ (de la figure 1) pris entre les instants $t_1$ et $t_3$, mais avec une courbe enveloppe qui n'est plus constituée d'un demi-cycle de sinusoïde mais d'un cycle d'un signal quasi-sinusoïdal à dérivées continues jusqu'à un ordre indéterminé, si tel est le cas pour le filtre d'émission.

Les filtres à retard imposant au signal d'entrée un retard $T=n\tau$ sont des lignes à retard à dispositif à transfert de charges.

Dans une autre réalisation le substrat 6 peut être du niobate de lithium ou tout autre matériau ayant des propriétés piézoélectriques.

**Revendications**

1. Dispositif de démodulation de signaux modulés par déplacement de fréquence à spectre minimal, ces signaux étant constitués de séquences de n trains d'oscillations (n entier supérieur à 1), chaque train ayant l'une ou l'autre de deux fréquences $F_1$ et $F_2$ et une durée $\tau$, et les séquences de n trains possibles étant déduites, par permutations circulaires, d'une séquence de base et représentatives d'un code binaire à permutation circulaire à n codes, caractérisé en ce que l'entrée (31) de ce dispositif est couplée aux voies d'entrée de deux voies de filtrage adaptées à une séquence d'accord qui est l'une des séquences du code, ces deux voies de filtrage ayant des voies d'entrée décalées de la durée $n\tau$ d'une séquence et une voie de sortie commune, cette voie de sortie étant couplée à un dispositif de détection ($I_i$, 7, 8) qui détecte dans le signal reçu par la voie de sortie, l'instant où ce signal correspond à la réponse attendue pour la séquence d'accord, la position de cet instant dans un intervalle nτ donnant le nombre de permutations circulaires de la séquence d'accord à la séquence reçue et donc la séquence codée reçue.

2. Dispositif de démodulation selon la revendication 1, caractérisé en ce que les voies de filtrage adaptées sont des filtres à ondes acoustiques de surface formés sur un substrat piézoélectrique (6) qui comporte au moins un transducteur d'entrée (5) ayant deux jeux d'électrodes interdigités sur la longueur correspondant à un temps de propagation égal à 2τ et définissant la forme de l'enveloppe de la réponse impulsionnelle du filtre, et un transducteur de sortie commun aux deux filtres comportant une succession de n paires d'électrodes ($e_i$, $e'_i$; i=1 à n+1) espacées l'une de la suivante d'une longueur ($l_1$) correspondant à un temps de propagation égal à τ, les premières électrodes des paires étant interconnectées et les secondes électrodes de ces paires formant n sorties parallèles d'une ligne à retard.

3. Dispositif de démodulation selon la revendication 2, caractérisé en ce que, dans le transducteur de sortie, les premières électrodes des paires ($e_i$) sont alternées avec les secondes électrodes des paires ($e_i$), et en ce que le dispositif de détection comporte n commutateurs électroniques ($l_i$) dont les entrées sont reliées à ces secondes électrodes et ayant des entrées de commande, un sommateur algébrique (7) ayant une entrée d'addition (35), une entrée de soustraction (36) et une sortie (38), pour coupler respectivement les sorties de la ligne à retard soit à l'entrée d'addition (+), soit à l'entrée de soustraction (−) du sommateur algébrique en fonction du signe des amplitudes des n+1 impulsions attendues pour la séquence d'accord.

4. Dispositif de démodulation selon la revendication 2, caractérisé en ce que, dans le transducteur de sortie, les positions respectives des première et seconde électrodes d'une paire sont établies en fonction du signe de l'amplitude de l'impulsion correspondante attendue pour la séquence d'accord, et en ce que le dispositif de détection comporte un sommateur (7) ayant des entrées couplées aux n sorties de la ligne à retard et une sortie.

5. Dispositif de démodulation selon la revendication 2, caractérisé en ce que les deux filtres à ondes acoustiques de surface comportent chacun un transducteur d'entrée, respectivement indentiques (4, 5), et destinés à recevoir les signaux modulés, ces deux transducteurs appartenant respectivement aux deux voies d'entrée et étant séparés d'une longueur correspondant à un temps de propagation des ondes acoustiques égal à nτ.

6. Dispositif de démodulation selon la revendication 2, caractérisé en ce qu'il comporte un même transducteur d'entrée (5) pour les voies d'entrée, ces deux voies d'entrées comportant un additionneur (9) ayant une première entrée reliée à l'entrée du dispositif, une deuxième entrée couplée à l'entrée du dispositif à travers un dispositif à retard nτ et une sortie couplée au transducteur d'entrée (5).

7. Dispositif de démodulation selon la revendication 7, caractérisé en ce que le dispositif à retard est un dispositif à transfert de charges.

**Claims**

1. Device for demodulation of signals modulated by multiple frequency shift keying, these signals being formed of sequences of n oscillation trains (n integer and greater than 1), each train having one or the other of two frequencies $F_1$ and $F_2$ and a duration τ, and the sequences of n possible trains being deduced from a base sequence by circular permutations and representing a circular permutation binary code of n codes, characterized in that the input (31) of this device is coupled to the input paths of two filter channels adapted to a tuning sequence which is one of the code sequences, these two filter channels having input paths shifted by the duration nτ of one sequence and a common output path, this output path being coupled to a detection device ($l_i$, 7, 8) detecting in the signal received through the output path the moment when this signal corresponds to the expected response for the tuning sequence, the position of said moment within an interval nτ yielding the number of circular permutations of the tuning sequence at the received sequence, and thus the received coded sequence.

2. Demodulation device in accordance with claim 1, characterized in that the adapted filter channels are acoustic surface wave filters formed on a piezoelectric substrate (6) comprising at least one input transducer (5) having two sets of electrodes interdigitated across a length corresponding to a propagation time equal to 2τ and defining the shape of the envelope of the pulse response of the filter, and an output transducer common to the two filters comprising a succession of n electrode pairs ($e_i$, $e'_i$; i=1 to n+1) spaced one from the following by a length ($l_1$) corresponding to a propagation time equal to τ, the first electrodes of the pairs being interconnected and the second electrodes of these pairs forming n parallel outputs of a delay line.

3. Demodulation device in accordance with claim 2, characterized in that the first electrodes of the pairs ($e_i$) of the output transducer alternate with the second electrodes of these pairs ($e_i$), and in that the detection device comprises n electronic switches ($l_i$), the inputs of which are connected to these second electrodes, and having control inputs, an algebraic summer (7) having an adding input (35), a subtraction input (36) and an output (38), for respectively coupling the outputs of the delay line either to the adding input (+) or to the subtracting input (—) of the algebraic summer depending on the sign of the amplitudes of the n+1 pulses expected for the tuning sequence.

4. Demodulation device in accordance with claim 2, characterized in that the respective position of the first and second electrodes of one pair of the output transducer are determined depending on the sign of the amplitude of the corresponding pulse expected for the tuning sequence, and in that the detection device comprises a summer (7) having inputs coupled to the n outputs of the delay line and an output.

5. Demodulation device in accordance with claim 2, characterized in that the two acoustic surface wave filters each comprise an identical input transducer (4, 5) intended to receive the modulated signals, these two transducers respectively belonging to the two input paths and being separated by a length corresponding to a propagation time of the acoustic wave equal to $n\tau$.

6. Demodulation device in accordance with claim 2, characterized in that it comprises the same input transducer (5) for the input paths, these two input paths comprising an adder (9) having a first input connected to the input of the device, a second input coupled to the input of the device through a $n\tau$ delay device and an output coupled to the input transducer (5).

7. Demodulation device in accordance with claim 7, characterized in that the delay device is a charge transfer device.

**Patentansprüche**

1. Vorrichtung zur Demodulation von Signalen, die durch Mehrfach-Frequenzumtastung moduliert sind, wobei diese Signale aus Folgen von n Schwingungszügen (n ganzzahlig und größer als 1) gebildet sind, jeder Zug die eine oder andere der beiden Frequenzen $F_1$ und $F_2$ und eine Dauer $\tau$ aufweist und die Folgen von n möglichen Zügen durch zyklische Vertauschung von einer Basisfolge abgeleitet sind und einen Binärcode mit zyklischer Vertauschung und n Codes darstellen, dadurch gekennzeichnet, daß der Eingang (31) dieser Vorrichtung an die Eingangszweige von zwei Filterkanälen angekoppelt ist, die an eine Abstimmfolge angepaßt sind, die eine der Folgen des Codes ist, wobei diese zwei Filterkanäle Eingangszweige, die um die Dauer $n\tau$ einer Folge verschoben sind, und einen gemeinsamen Ausgangszweig aufweisen, wobei dieser Ausgangszweig an eine Detektionsvorrichtung ($I_i$, 7, 8) angekoppelt ist, die in dem über den Ausgangszweig empfangenen Signal den Zeitpunkt feststellt, zu dem dieses Signal der erwarteten Antwort für die Abstimmfolge entspricht, und wobei die Lage dieses Zeitpunktes in einem Interval $n\tau$ die Anzahl von zyklischen Permutationen der Abstimmfolgen bei der empfangenen Folge und folglich die empfangene codierte Folge ergibt.

2. Demodulationsvorrichtung nach Anspruch 1, dadurch gekennzeichnet, daß die angepaßten Filterkanäle akustische Oberflächenwellenfilter sind, die auf einem piezoelektrischen Substrat (6) gebildet sind, das wenigstens einen Eingangswandler (5) mit zwei Elektrodenpaaren umfaßt, die auf einer der Ausbreitungszeit $2\tau$ entsprechenden Länge verschachtelt sind und die Gestalt der Einhüllenden der Impulsantwort des Filters definieren, und einen den beiden Filtern gemeinsamen Ausgangswandler aufweist, der eine Aufeinanderfolge von n Elektrodenpaaren ($e_i$, $e'_i$; i=1 bis n+1), aufweist, die jeweils voneinander den Abstand einer Strecke ($l_1$) haben, welche einer Ausbreitungszeit von $\tau$ entspricht, wobei die ersten Elektroden der Paare untereinander verbunden und die zweiten Elektroden dieser Paare n parallele Ausgänge einer Verzögerungsleitung bilden.

3. Demodulationsvorrichtung nach Anspruch 2, dadurch gekennzeichnet, daß in dem Ausgangswandler die ersten Elektroden der Paare ($e_i$) mit den zweiten Elektroden der Paare ($e_i$) abwechseln und daß die Detektionsvorrichtung n elektronische Schalter ($I_i$), deren Eingänge mit diesen zweiten Elektroden verbunden sind und die Steuereingänge aufweisen, und einen algebraischen Summierer (7) umfaßt, der einen Additionseingang (35), einen Subtraktionseingang (36) und einen Ausgang (38) umfaßt, um jeweils die Ausgänge der Verzögerungsleitung entweder mit dem Additionseingang (+) oder mit dem Subtraktionseingang (—) des algebraischen Summierers zu verbinden, in Abhängigkeit vom Vorzeichen der Amplituden der n+1 für die Abstimmfolge erwarteten Impulse.

4. Demodulationsvorrichtung nach Anspruch 2, dadurch gekennzeichnet, daß in dem Ausgangswandler die jeweiligen Lagen der ersten und der zweiten Elektrode eines Paares in Abhängigkeit vom Vorzeichen der Amplitude des entsprechenden Impulses, der für die Abstimmfolge erwartet wird, festgelegt sind, und daß die Detektionsvorrichtung einen Summierer (7) umfaßt, der mit den n Ausgängen der Verzögerungsleitung gekoppelte Eingänge und einen Ausgang aufweist.

5. Demodulationsvorrichtung nach Anspruch 2, dadurch gekennzeichnet, daß die beiden akustischen Oberflächenwellenfilter jeweils einen gleichen Eingangswandler (4, 5) umfassen, der dazu bestimmt ist, die modulierten Signale zu empfangen, wobei diese Wandler jeweils dem einen bzw. anderen Eingangszweig zugehörig sind und voneinander um eine Strecke getrennt sind, die einer Ausbreitungszeit $n\tau$ der akustischen Wellen entspricht.

6. Demodulationsvorrichtung nach Anspruch 2, dadurch gekennzeichnet, daß sie ein und denselben Eingangswandler (5) für die Eingangszweige aufweist, wobei die zwei Eingangszweige einen Addierer (9) umfassen, der einen ersten, mit dem Eingang der Vorrichtung verbundenen Eingang, einen zweiten, mit dem Eingang der Vorrichtung über eine $n\tau$-Verzögerungseinrichtung verbundenen Eingang und einen mit dem Eingangswandler (5) gekoppelten Ausgang aufweist.

7. Demodulàtionsvorrichtung nach Anspruch 7, dadurch gekennzeichnet, daß die Verzögerungseinrichtung eine Ladungsverschiebevorrichtung ist.

# FIG_1

# FIG_3

# FIG_2

# FIG_4

# FIG_5

2